# EUROPEAN PATENT APPLICATION

(11) **EP 2 506 683 A1**
(43) Date of publication of application: **03.10.2012**
(21) Application number: 10833134.9
(22) Date of filing: 18.11.2010
(51) Int. Cl.: H05B 33/10, B05D 7/00, H01L 51/50, H05B 33/12

(54) **MANUFACTURING METHOD OF LIGHT EMITTING DEVICE**

(30) Priority: 24.11.2009 JP 2009266022
(71) Applicant: Sumitomo Chemical Co., Ltd, Chuo-ku, Tokyo 104-8260 (JP)
(72) Inventor: SHAKUTSUI Masato, Tsukuba-shi Ibaraki 305-0005 (JP); GODA Tadashi, Tsukuba-shi Ibaraki 305-0821 (JP)
(74) Representative: Jackson, Martin Peter
(86) International application number: PCT/JP2010/070608
(87) International publication number: WO 2011/065288

(57) **Abstract**

There is provided a method for manufacturing a light emitting device including a plurality of organic EL elements, in which a plurality of rows extending in a row direction different from a predetermined column direction are set at predetermined intervals in the column direction on a plane, and the plurality of organic EL elements are provided in each of the rows at predetermined intervals in the row direction. Each of the plurality of organic EL elements includes a pair of electrodes, and a common layer that is commonly provided for each of the organic EL elements between the electrodes. The method for manufacturing a light emitting device includes a step of forming the common layer. In the step of forming the common layer, the process of applying and forming the common layer is performed (m+1) times at intervals of m row in the column direction to the rows in which the common layer is not formed.

## Description

### Technical Field

The present invention relates to a method for manufacturing a light emitting device.

### Background Art

There are various types of display devices, such as liquid-crystal displays, and plasma displays, and among them, there is a display device in which an organic EL (Electro Luminescence) element is used as a pixel light source.

The organic EL elements are aligned and arranged on a substrate in the display device. A plurality of partition walls for partitioning the organic EL elements are arranged in a stripe shape on the substrate. In other words, a plurality of recessed sections corresponding to the plurality of partition walls are provided in the stripe shape on the substrate. The plurality of organic EL elements are provided in the plurality of recessed sections, respectively. In each of the recessed sections, the organic EL elements are arranged at predetermined intervals along the extending direction of the recessed section (hereinafter, "the extending direction of the recessed section" may be referred to as a row direction and the direction perpendicular to the row direction may be referred to as a column direction).

In a color display device, three kinds of organic EL elements, which respectively emit red, green and blue light, are provided in order to represent a desired color. For example, a color display device is realized by repeatedly arranging in order in the column direction the following three rows of (I) to (III), in each of which a plurality of organic EL elements emitting one of red, green and blue light are arranged in the recessed section.
(I) The row in which a plurality of organic EL elements emitting red light are arranged at predetermined intervals.
(II) The row in which a plurality of organic EL elements emitting green light are arranged at predetermined intervals.
(III) The row in which a plurality of organic EL elements emitting blue light are arranged at predetermined intervals.

The organic EL element is constituted by a pair of electrodes, and a plurality of organic layers provided between the electrodes. In the organic EL element, at least one light emitting layer is provided as the plurality of organic layers. Each of the three kinds of organic EL elements described above can be manufactured by forming the light emitting layer emitting one of red, green and blue light according to the kind of organic EL element. In this case, according to the kind of organic EL element, a light emitting layer emitting light of a predetermined color needs to be formed in a predetermined row (recessed section). For example, when a light emitting layer emitting red light is to be formed, the light emitting layer emitting red light can be formed in such a manner that an ink containing a material to be formed as the light emitting layer emitting red light is supplied to a row (recessed section) in which the light emitting layer is to be formed, and further the ink is solidified. The light emitting layers which emit blue light and green light are formed in the similar manner. When the three kinds of light emitting layers are to be formed respectively in predetermined rows (recessed sections) in this way, it is necessary to separately apply the ink of each color to the row (recessed section) in which the corresponding layer of the three kinds of light emitting layers is to be formed.

On the other hand, a layer, such as, for example, a hole injection layer and a hole transport layer, which does not much affect the emission color, can be provided as a layer (hereinafter may be referred to as a common layer) common to all the three kinds of organic EL elements, irrespective of the emission color of the organic EL element. When such common layer is formed, the ink containing the material to be formed as the common layer need not be separately applied to each of the predetermined rows (recessed sections). For this reason, the common layer for all the organic EL elements can also be formed at once in such a manner that the ink is applied to all the surface of the substrate by using a method such as a spin-coating method (see, for example, Patent Literature 1).

### Citation List

### Patent Literature

Patent Literature 1: Japanese Patent Laid-Open No. 2009-54522

### Summary of Invention

### Technical Problem

When the ink is applied to all the surface of the substrate at the time of forming the common layer, the ink is applied not only to the area between the partition walls (recessed section) but also on the partition wall. Most of the ink applied on the partition wall flows into the recessed section as the ink dries, but a part of the ink may remain on the partition wall. As a result, the common layer is formed, in some cases, on the partition wall on which the common layer is not intended to be formed.

In the case where the common layer is formed on a portion on which the common layer is not intended to be formed, there are problems that, in some cases, the film thickness of the common layer formed between the partition walls (recessed sections) becomes smaller than the intended film thickness, and that, in some cases, electric conduction is caused in an unintended portion due to the common layer formed on the partition wall and thereby a leakage current is caused.

In order to solve the above-described problems, a method was investigated in which the common layer is formed only between the adjacent partition walls (in the recessed section) in such a manner that the ink is supplied only between the partition walls (in the recessed section) by using a nozzle coating method instead of using the method of applying the ink onto the whole surface of the substrate. However, it was confirmed that the following problems are caused by this method.

In the nozzle coating method, the ink is supplied to all the rows (recessed sections) with a so-called single stroke of the pen. That is, the ink is supplied to all of the rows (recessed sections) in such a manner that, while ink in the form of a liquid column is discharged from a nozzle arranged above the substrate, the nozzle is reciprocated in the row direction and that the substrate is moved by one row in the column direction when returning the reciprocating movement. The nozzle is reciprocated in the row direction not only in the region where the organic EL elements are formed but also even in a region outside the region where the organic EL elements are formed. The partition walls are provided in each of the regions where the organic EL elements are formed, but are not provided in the region outside the region where the organic EL elements are formed. Therefore, when the nozzle coating method is used, the ink is applied even in the region where the partition walls are not provided.

The movement of the ink applied to the region where the partition walls are provided is suppressed by the recessed section. However, there is nothing to regulate the movement of the ink which is applied to the region where the partition walls are not provided, that is, there is nothing to regulate the movement of the ink applied to the end portion in the row direction. Therefore, the ink supplied to this region is wetly spread on the substrate so as to be connected with the ink of the next row and, in some cases, to be eventually connected in the column direction. When the ink supplied between the partition walls (recessed section) dries, a part of the ink is, in some cases, moved so as to be drawn into the ink connected in the column direction. As a result, in some cases, the film thickness of the common layer of the organic EL element formed in the end portion in the row direction becomes smaller than the thickness of the common layer of the organic EL elements formed in the other portion. Further, the ink is supplied in an amount so as not to overflow into the next row, but the amount is large. Therefore, on the partition wall, the ink supplied to a predetermined row is, in some cases, connected to the ink supplied to the next row. As a result, in some cases, the common layer is formed on the partition wall, which results in the same problem as that in the case where the ink is applied onto the whole surface of the substrate.

Therefore, an object of the invention is to provide a method for manufacturing a light emitting device including a plurality of organic EL elements, the method being capable of forming a common layer having a uniform film thickness over the plurality of organic EL elements by using a method of applying ink in the form of a liquid column.

### Solution to Problem

The present invention relates to a method for manufacturing a light emitting device including a plurality of organic EL elements. In the method according to the present invention, a plurality of rows extending in a row direction different from a predetermined column direction are set on a plane at predetermined intervals in the column direction, and the plurality of organic EL elements are provided in each of the rows at predetermined intervals in the row direction. Each of the plurality of organic EL elements includes a pair of electrodes, and a common layer which is commonly provided for each of the organic EL elements between the electrodes. The common layers of the organic EL elements are formed in different rows, and has the same film thickness.

The method for manufacturing a light emitting device including a plurality of organic EL elements includes: a step of forming one-side electrode of the pair of electrodes; a step of forming the other-side electrode of the pair of electrodes; and a step of forming a common layer by applying and forming the common layer in a predetermined row in such a manner that, while ink in the form of a liquid column and containing a material to be formed as the common layer is supplied to the predetermined row, the ink supply position is moved in the row direction. In the step of forming the common layer, the process of applying and forming the common layer is performed (m+1) times (symbol "m" denotes a natural number) at intervals of m row in the column direction to the rows in which the common layer is not formed.

In the method according to the present invention, the supply amount of the ink per unit length in the row direction may be adjusted for each process so that the common layers formed in different rows have the same film thickness.

In the method according to the present invention, the supply amount of the ink per unit length in the row direction in the succeeding process may be set smaller than the supply amount of the ink per unit length in the row direction in the preceding process.

In the method according to the present invention, the supply amount of the ink may be adjusted by adjusting the moving speed of the ink supply position in the row direction.

In the method according to the present invention, the supply amount of the ink may be adjusted by adjusting the supply amount of the ink per unit time.

In the method according to the present invention, the value of m may be set to 1.

Further, the present invention relates to a method for manufacturing a plurality of thin films. In the method, a plurality of rows extending in a row direction different from a predetermined column direction are set on a predetermined substrate at predetermined intervals in the column direction, and each of the plurality of thin films is formed in each of the rows so as to have the same thickness. The method for manufacturing a plurality of thin films includes a step of forming thin films by applying and forming the thin films in predetermined rows in such a manner that, while ink in the form of a liquid column and containing a material to be formed as the thin films is supplied to the predetermined rows, the ink supply position is moved in the row direction. In the step of forming the thin films, the process of applying and forming the thin films is performed (m+1) times (symbol "m" denotes a natural number) at intervals of m row in the column direction to the rows not provided with the thin films.

### Advantageous Effects of Invention

In the present invention, the common layers are applied and formed at intervals of m rows in the column direction. In this case, the interval between the rows to which the ink is applied is increased as compared with the case where the common layer is applied and formed without intervals in the column direction. Thereby, it is possible to prevent the ink from being connected in the column direction at the end portion in the row direction. Further, since the ink is not applied to the rows adjacent to each other, it is possible to prevent that the ink supplied to a predetermined row is connected, on the partition wall, to the ink supplied to the next row. Thereby, a common layer having a uniform thickness and common to a plurality of organic EL elements can be formed by using the method of supplying ink in the form of a liquid column.

### Brief Description of Drawings

[Figure 1] Figure 1 is a plan view schematically showing a light emitting device 1 according to a present embodiment.
[Figure 2] Figure 2 is a cross-sectional view schematically showing the light emitting device 1.
[Figure 3] Figure 3 is a plan view schematically showing a state immediately after a first process is performed.
[Figure 4] Figure 4 is a cross-sectional view schematically showing the state immediately after the first process is performed.
[Figure 5] Figure 5 is a plan view schematically showing a state immediately after a second process is performed.
[Figure 6] Figure 6 is a cross-sectional view schematically showing the state immediately after the second process is performed.

### Description of Embodiments

In a method for manufacturing a light emitting device according to an embodiment of the present invention, a plurality of rows extending in a row direction different from a predetermined column direction are set on a plane at predetermined intervals in the column direction. In this method, each of a plurality of organic EL elements provided in the row at a predetermined interval in the row direction includes a pair of electrodes and a common layer that is commonly provided for each of the organic EL elements between the electrodes. The common layer of the organic EL elements formed in different rows having the same film thickness.

The method for manufacturing a light emitting device provided with a plurality of organic EL elements includes a step of forming one-side electrode of the pair of electrodes, a step of forming the other-side electrode of the pair of electrodes, and a step of forming the common layer by applying and forming the common layer in a predetermined row in such a manner that, while ink in the form of a liquid column and containing a material to be formed as the common layer is supplied to the predetermined row, the ink supply position is moved in the row direction. In the step of forming the common layer, the process of applying and forming the common layer is performed (m+1) times (symbol "m" denotes a natural number) at intervals of m rows in the column direction to the rows not provided with the common layer.

The light emitting device is used, for example, as a display device. Examples of the display devices mainly include an active matrix drive type device, and a passive matrix drive type device. In the present embodiment, an active matrix drive type display device is described as an example of the display device.

### <Configuration of light emitting device>

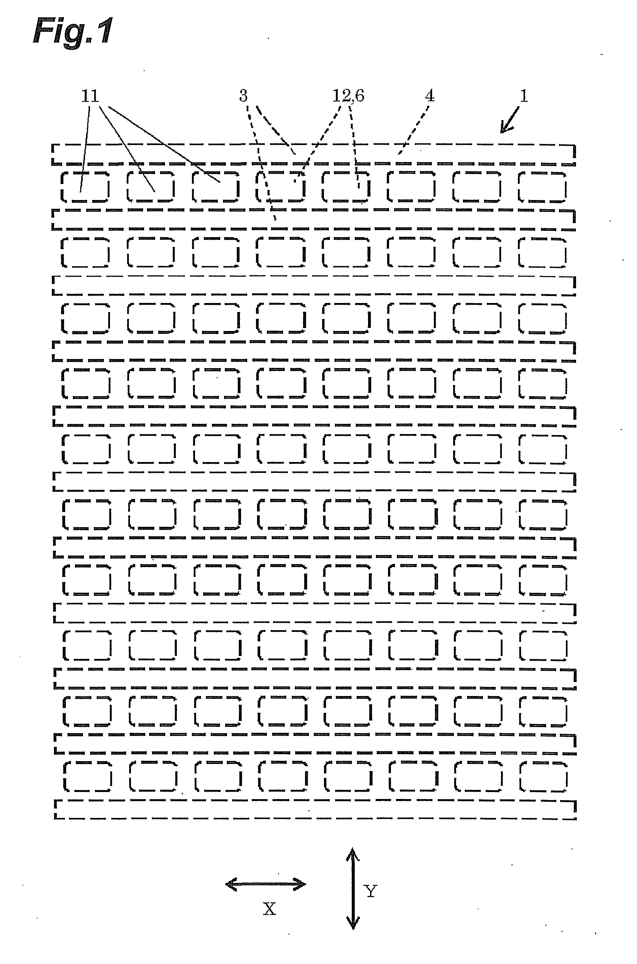

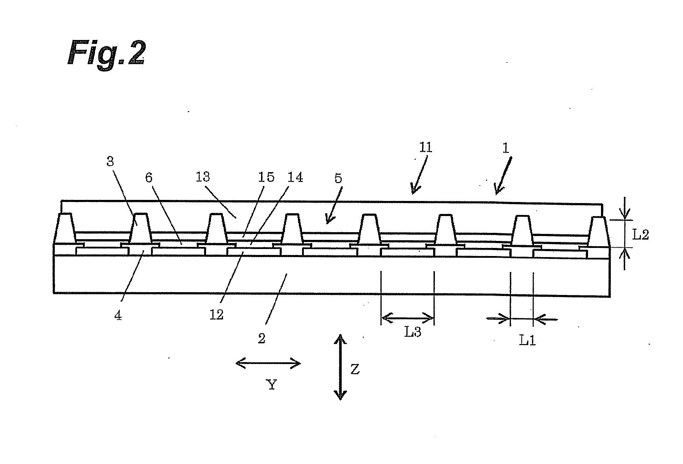

First, a configuration of a light emitting device is described. Figure 1 is a plan view schematically showing a light emitting device 1 according to a present embodiment. Figure 2 is a cross-sectional view schematically showing the light emitting device 1. The light emitting device 1 is configured by including a support substrate 2, a plurality of organic EL elements 11 formed on the support substrate 2, partition walls 3 provided to partition the plurality of organic EL elements 11, and an insulating film 4 for electrically insulating each of the organic EL elements 11.

In the present embodiment, the plurality of organic EL elements 11 are aligned and arranged in a matrix form on the support substrate 2, respectively. That is, the plurality of organic EL elements 11 are respectively arranged at predetermined intervals in the row direction X and at predetermined intervals in the column direction Y In the present embodiment, the row direction X and the column direction Y are perpendicular to each other and are respectively perpendicular to the thickness direction Z of the support substrate 2.

In the present embodiment, the plurality of partition walls 3 extending in the row direction X are provided on the support substrate 2. The partition walls 3 are formed in a so-called stripe form in plan view. Each of the partition walls 3 is provided between the organic EL elements 11 adjacent to each other in the column direction Y. In other words, the plurality of organic EL elements 11 are formed between the partition walls 3 adjacent to each other in the column direction Y, and are arranged between the mutually adjacent partition walls 3 at predetermined intervals in the row direction X. In the following, a recess defined by a pair of the partition walls adjacent to each other in the column direction Y, and by the support substrate is, in some cases, referred to as a recessed section 5, and each of the plurality of recessed sections 5 corresponds to a predetermined row.

In the present embodiment, the lattice-like insulating film 4 electrically insulating each of the organic EL elements 11 is provided between the support substrate 2 and the partition walls 3. The insulating film 4 is configured by integrally forming a plurality of plate-like members extending in the row direction X, and a plurality of plate-like members extending in the column direction Y An opening 6 of the lattice-like insulating film 4 is formed at a position at which the opening 6 overlaps with the organic EL element 11 in plan view. The opening 6 of the insulating film 4 is formed into a shape such as, for example, an oval gold shape, a substantially circular shape, a substantially elliptical shape, and a substantially rectangular shape in plan view. The partition wall 3 described above is formed on the member extending in the row direction X and constituting a part of the insulating film 4. The insulating film 4 is formed according to its purpose as required. For example, the insulating film 4 is provided in order to secure the electrical insulation between the organic EL elements in the row direction X.

The organic EL element 11 is configured by including a pair of electrodes, and one or more light emitting layers provided between the electrodes. In the present embodiment, a common layer provided in common for each of the organic EL elements 11 is provided between the pair of electrodes. Examples of the common layer include, for example, an organic layer different from the light emitting layer, a layer containing an inorganic substance and an organic substance, an inorganic layer, and the like. Specifically, so called a hole injection layer, a hole transport layer, an electron blocking layer, a hole blocking layer, an electron transport layer, an electron injection layer, and the like, are provided as the common layer. Figure 2 shows, as an example, the organic EL element 11 in which a common layer 14 and a light emitting layer 15 are provided between a pair of electrodes 12 and 13. As will be described below, the organic EL element 11 is configured by laminating, for example, an anode corresponding to the one-side electrode 12 of the pair of electrodes 12 and 13, a hole injection layer corresponding to the common layer 14, the light emitting layer 15, and a cathode corresponding to the other-side electrode 13 of the pair of electrodes 12 and 13 in this order from the side of the support substrate 2. In the following, the organic EL element is described which is configured such that the common layer 14 is arranged nearer the one-side electrode 12 than the light emitting layer 15. However, the present invention is not limited to this configuration, and the common layer 14 may be arranged nearer the other-side electrode 13 than the light emitting layer 15. Further, the common layer 14 may also be arranged between the light emitting layer 15 and each of the one-side electrode 12 and the other-side electrode 13.

The pair of electrodes 12 and 13 are configured as an anode and a cathode, respectively. One of the anode and the cathode is arranged, as the one-side electrode 12 of the pair of electrodes 12 and 13, on the side near the support substrate 2. The other of the anode and the cathode is arranged, as the other-side electrode 13 of the pair of electrodes 12 and 13, at a position farther away from the support substrate than the one-side electrode 12.

The light emitting device 1 according to the present embodiment is an active matrix type device, and hence the one-side electrode 12 is provided for each of the organic EL elements 11. For example, the one-side electrode 12 has a plate shape and is formed in a substantially rectangular shape in plan view. The one-side electrodes 12 are provided on the support substrate 2 in a matrix form so as to respectively correspond to the positions at which the organic EL elements are provided. The one-side electrodes 12 are arranged at predetermined intervals in the row direction X and are also arranged at predetermined intervals in the column direction Y That is, in plan view, the one-side electrodes 12, each of which is arranged between the partition walls 3 adjacent to each other in the column direction Y, are arranged between the partition walls 3 at the predetermined intervals in the row direction X.

The insulating film 4 provided in the lattice form as described above is mainly formed, in plan view, in the region except the one-side electrode 12 and is formed so that a part of the insulating film 4 covers the peripheral edge of the one-side electrode 12. In other words, the opening 6 of the insulating film 4 is formed on the one-side electrode 12. The surface of the one-side electrode 12 is exposed by the opening 6 from the insulating film 4. The plurality of partition walls 3 described above are respectively provided on the plurality of plate-like members, each constituting a part of the insulating film 4 and extending in the row direction X.

The common layer 14 is arranged in the region sandwiched between the partition walls 3 so as to extend in the row direction X. That is, the common layer 14 is formed in a plate shape in the recessed section 5 defined by the partition walls 3 adjacent to each other in the column direction Y. The common layer 14 is provided in each of the plurality of rows, but in the present embodiment, the common layer 14 is formed so that the common layers 14 formed in all the rows have the same film thicknesses. That is, the common layer 14 is formed so that the common layers formed in the different rows have the same film thicknesses.

Similarly to the common layer 14, the light emitting layer 15 is arranged in the region sandwiched between the partition walls 3 so as to extend in the row direction X. That is, the light emitting layer 15 is formed in a plate shape in the recessed section 5 defined by the partition walls 3 adjacent to each other in the column direction Y. In the present embodiment, the light emitting layer 15 is provided so as to be laminated on the common layer 14.

As described above, in the case of a color display device, three kinds of organic EL elements, which respectively emit light of, for example, red, green, and blue, need to be provided on the support substrate 2. Specifically, (I) the row in which a plurality of organic EL elements emitting red light are arranged at predetermined intervals, (II) the row in which a plurality of organic EL elements emitting green light are arranged at predetermined intervals, and (III) a row in which a plurality of organic EL elements emitting blue light are arranged at predetermined intervals are repeatedly arranged in this order in the column direction Y. Thereby, a light emitting device for use in the color display device can be realized.

In the present embodiment, each of three kinds of organic EL elements, which respectively emit red light, green light, and blue light, is manufactured by changing the kind of light emitting layer. For this reason, the three kinds of rows of (i) the row provided with the light emitting layer emitting red light, (ii) the row provided with the light emitting layer emitting green light, and (iii) the row provided with the light emitting layer emitting blue light are repeatedly arranged in the column direction Y That is, each of the light emitting layer emitting red light, the light emitting layer emitting green light, and the light emitting layer emitting blue light is successively laminated on the common layer as a plate-like layer which extends in the row direction X and which is provided at intervals of two rows in the column direction Y.

The other-side electrode 13 of the pair of electrodes 12 and 13 is provided on the light emitting layer 15. In the present embodiment, the other-side electrode 13 is continuously formed over the plurality of organic EL elements, so as to be provided as an electrode common for the plurality of organic EL elements 11. That is, the other-side electrode 13 is formed not only on the light emitting layer 15 but also on the partition wall 3, and is formed into one surface so that the electrode on the light emitting layer 15 and the electrode on the partition wall 3 are connected to each other.

### <Method for manufacturing light emitting device>

Next, a method for manufacturing the display device is described.

First, the support substrate 2 is prepared. In the case of the active matrix type display device, a substrate, in which a drive circuit for individually driving the plurality of organic EL elements 11 is formed in advance, can be used as the support substrate 2. For example, a TFT (Thin Film Transistor) substrate can be used as the support substrate.

### (Step of forming one-side electrode of paired electrodes on support substrate)

Next, a plurality of the one-side electrodes 12 are formed in a matrix form on the prepared support substrate 2. The one-side electrode 12 is formed, for example, in such a manner that a conductive thin film is formed on one surface of the support substrate 2 and that the conductive thin film is patterned in a matrix form by using a photolithography method. Further, the pattern of the one-side electrode 12 may also be formed, for example, in such a manner that a mask having openings, each of which is formed in a portion corresponding to the pattern of the one-side electrode 12 to be formed, is arranged on the support substrate 2, and that a conductive material is selectively deposited on the predetermined portions on the support substrate 2 via the mask. The material of the one-side electrode 12 will be described below. In this step, the support substrate on which the one-side electrode 12 is formed in advance may also be prepared.

Next, in the present embodiment, the insulating film 4 is formed in a lattice form on the support substrate 2. The insulating film 4 is formed of an organic material or an inorganic material. Examples of the organic material constituting the insulating film 4 include resins, such as acrylic resins, phenol resins, polyimide resins, and the like. Examples of the inorganic material constituting the insulating film include materials, such as SiO₂, SiN, and the like.

When the insulating film made of an organic material is formed, a photosensitive resin of a positive type or a negative type is first applied onto one surface, and predetermined portions of the applied resin are exposed and developed. Then, the exposed and developed photosensitive resin is cured, so that the insulating film 4 having the openings 6 formed in the predetermined portions is formed. A photoresist can be used as the photosensitive resin. When the insulating film made of an inorganic material is formed, a thin film made of an inorganic material is formed on the whole surface by a plasma CVD method, a sputtering technique, or the like. Next, the insulating film 4 is formed by forming the openings 6 in predetermined portions. The openings 6 are formed, for example, by a photolithography method. The surface of the one-side electrode 12 is exposed by forming the openings 6.

Next, in the present embodiment, a plurality of the partition walls 3 are formed in a stripe form on the insulating film 4. The partition walls 3 can be similarly formed in the stripe form, for example, by using the material exemplified as the material of the insulating film and by using the method of forming the insulating film 4.

The shape and arrangement of the partition walls 3 and the insulating films 4 are appropriately determined according to the specifications of the display device, such as the number of pixels, and the resolution of the display device, and the ease of manufacture. For example, the thickness L1 in the column direction Y of the partition wall 3 is about 10 µm to about 100 µm, and the height L2 of the partition wall 3 is about 0.5 µm to about 5 µm. The interval L3 between the partition walls 3 adjacent to each other in the column direction Y, that is, the width L3 of the recessed section 5 in the column direction Y is about 50 µm to about 300 µm. The width in each of the row direction X and the column direction Y of the opening 6 formed in the insulating film 4 is about 50 µm to about 300 µm.

### (Step of forming common layer)

Next, in the present embodiment, the common layer 14 is formed on the one-side electrode 12. In this step, the common layer 14 is formed by applying and forming a common layer in a predetermined row in such a manner that, while ink in the form of a liquid column and containing a material to be formed as the common layer 14 is supplied to the predetermined row, the ink supply position is moved in the row direction. That is, the common layer 14 is formed by a so-called nozzle coating method. In the present embodiment, the common layer 14 is formed in such a manner that an ink containing a material to be formed as a hole injection layer is applied by the nozzle coating method so that the common layers 14 formed in the different rows have the same film thickness. Further, specifically, the common layer 14 of each row is formed in such a manner that a process of applying and forming the common layer 14 at intervals of m rows (symbol "m" denotes a natural number) in the column direction is performed (m+1) times to the rows in which the common layer 14 not formed.

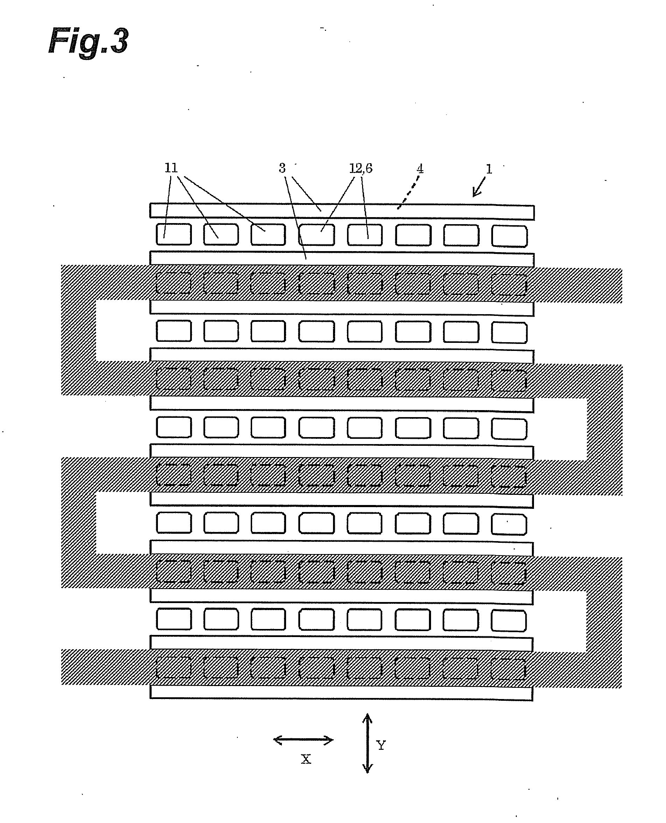

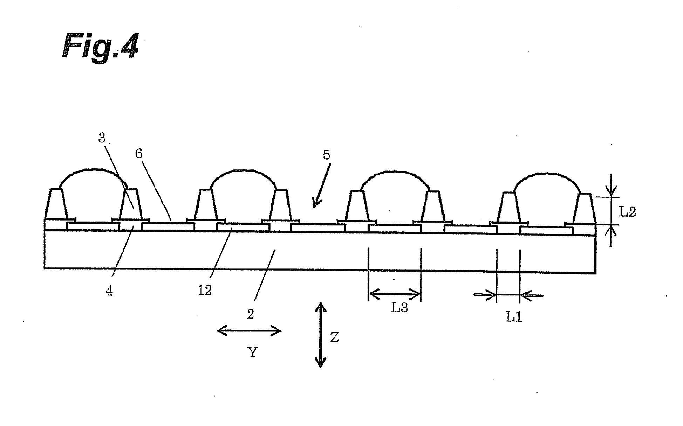

As long as m is a natural number, m is not limited to "1", but in the following, the case of m = 1 is described more specifically with reference to Figure 3 and Figure 4. In the case of m = 1, the common layer 14 is formed in all the rows by performing two times the process of applying and forming the common layer at intervals of one row. In other words, the common layer 14 is applied and formed by being divided into the layers in even rows and the layers in odd rows.

In the nozzle coating method, the ink is supplied to each row (recessed section) by a so-called single stroke of the pen. Since m = 1 in the present embodiment, the ink is supplied to each row (recessed section) with a so-called single stroke of the pen at intervals of one row, so that the ink is supplied by dividing the ink supply process into two processes of a process for even rows and a process for odd rows. That is, while, in the state where the ink in the form of a liquid column is discharged from a nozzle arranged above the support substrate 2, the nozzle is reciprocated in the row direction X, the substrate is moved by two rows in the column direction when returning the reciprocating movement of the nozzle so that the ink is supplied at intervals of one row. Specifically, the ink is supplied at intervals of one row by repeatedly performing, in order, the following operations (1) to (4). That is, while the ink in the form of a liquid column is discharged from the nozzle, (1) the nozzle is moved on a predetermined row in the row direction from one end to the other end of the reciprocating movement (outward path), (2) the support substrate 2 is moved by two rows in the column direction Y (return point), (3) the nozzle is moved on a predetermined row in the row direction from the other end to the one end of the reciprocating movement (homeward path), and (4) the support substrate 2 is moved by two rows in the column direction Y (return point).

In the first process, the ink is applied to the even rows on the substrate shown in Figure 1. Figure 3 and Figure 4 schematically show the state immediately after the first process is performed. In Figure 3, the region to which the ink is applied is hatched. As shown in Figure 4, in a sectional view taken along a plane perpendicular to the row direction X, the cross section of the applied liquid has a dome shape. However, the ink is not applied to the next row (odd row), and hence the ink supplied to the even row and the ink supplied to the next row (odd row) are not connected to each other on the partition wall 3. Further, the interval in the column direction Y between the rows, to which the ink is supplied, is increased as compared with the case where the ink is supplied to each row. Therefore, it is possible to prevent the ink of the adjacent rows from connecting to each other at the end portion in the row direction.

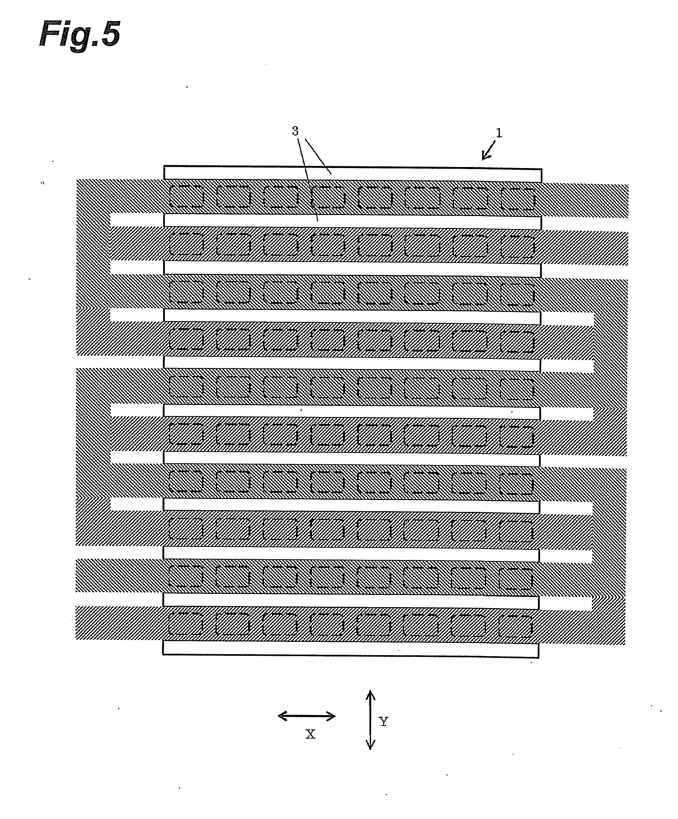

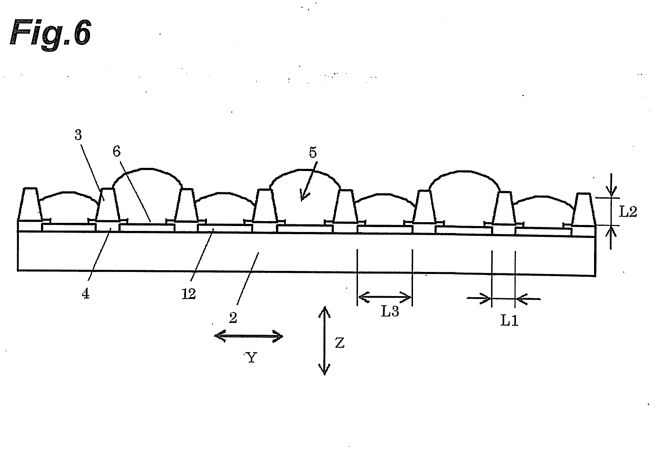

In the second process, the ink is applied to the odd rows on the substrate shown in Figure 1. In the second process, similarly to the first process, the ink is supplied, with a so-called single stroke of the pen, to each of the rows (recessed sections) in which the common layer is not formed. That is, the ink is supplied to the odd rows to which the ink is not applied in the first process. Figure 5 and Figure 6 schematically show the state immediately after the second process is performed. As shown in Figure 5, the ink is applied to all the rows by performing twice the process of applying and forming the common layer 14 at intervals of one row. In Figure 5, the ink applied in the second process is also hatched, and the inclination of the hatching lines for the ink applied in the first process is made different from the inclination of the hatching lines for the ink applied in the second process.

As shown in Figure 6, when the second process is performed, the ink applied in the first process is retained in the inside of the recessed section 5. This is because, as a part of the ink dries by evaporation of the solvent of the ink with time, the volume of the ink is reduced, so that the ink applied to the partition wall is moved to the inside of the recessed section 5 according to the reduction in the volume of the ink. In this way, when, the second process is performed, the ink applied in the first process does not exist on the partition wall 3. Therefore, even when the ink is applied even to the partition wall in the second process, it is possible to avoid that the ink on the partition wall 3 and the ink of the next row are connected to each other. When the ink on the partition wall 3 and the ink of the next row are separated from each other without being connected to each other, the ink applied to the partition wall 3 shrinks due to evaporation of the solvent, and is retained in the recessed section between the partition walls 3 without being drawn by the ink of the next row. Therefore, it is possible to prevent an intermediate layer from being formed on the partition wall 3.

Further, in Figure 5, it seems that, similarly to the case where the ink is supplied to each row at no interval of row, the ink applied in the first process and the ink applied in the second process approach each other in the column direction at both ends in the row direction X. However, as described above, when the coating liquid is applied in the second process, a part of the ink applied in the first process is dry, and hence the coating liquid applied in the second process is hardly affected by the ink applied to the end portion in the row direction X in the first process. Therefore, when the ink is applied at intervals of one row in the second process, the interval in the column direction Y between the rows to which the ink is applied is increased similarly to the first process, and hence it is possible to prevent the ink from being connected at the end portion in the row direction X.

The common layer 14 can be formed by solidifying the ink supplied between the partition walls 3. The thin film can be solidified, for example, by removing the solvent of the ink. The solvent can be removed by natural drying, heat drying, vacuum drying, and the like. Further, when the ink containing a material, which is polymerized by application of energy, such as light and heat, is used, the thin film may be solidified by applying energy, such as light or heat, after the application of the ink.

As described above, when the common layer 14 is applied and formed at intervals of m rows in the column direction, it is possible to prevent that, at the time of application of the ink, the ink is connected at the end portion in the row direction, and also the ink supplied to the rows, which are adjacent to each other via the partition wall 3, is connected on the partition wall 3. Thereby, the common layers 14 having the same thickness can be formed in a plurality of rows, respectively. In the present embodiment, the film thickness means the film thickness at the thinnest portion on the one-side electrode 12. The fact that the film thickness is the same means that the film thickness is the same to the extent that the difference in luminosity due to the difference in the film thickness is not perceived at the time of use of the light emitting device. Specifically, the fact that the film thickness is the same means that, when the arithmetic mean of the film thicknesses of all the rows is used as a reference, the film thickness of each of the common layers is in the range of (the arithmetic mean of the film thicknesses) × 0.8 to (the arithmetic mean of the film thicknesses) × 1.2.

In the present embodiment, the case of m = 1 is described, but m is not limited to 1. As long as m is a natural number, m may be 2 or more. In this way, even in the case where m is 2 or more, when the ink is supplied at intervals of m rows in the column direction, it is possible, similarly to the case of m = 1, to prevent that the ink is connected at the end portion in the row direction, and also the ink supplied to the rows adjacent to each other is connected on the partition wall 3. Thereby, the common layers 14 having the same thickness can be formed in a plurality of rows.

The value of m may be a natural number, but a smaller value of m is preferred, and the value of m = 1 is most preferred. This is because, in order to apply the ink to all the rows, the process needs to be performed (M+1) times, and because, as the value of m is reduced, the number of times of performing the process is reduced and thereby the time required to form all the common layers is reduced.

In the present embodiment, the process of applying the ink by using one nozzle is described, but the number of nozzles is not limited to one. The ink may be applied by using a plurality of nozzles. In this case, a plurality of nozzles may be arranged at intervals of m rows in the column direction. When the plurality of nozzles are located at the end of their reciprocating movement in the row direction X, the support substrate 2 may be moved by a predetermined distance in correspondence with the number of nozzles so that the ink is applied at intervals of m rows in the column direction.

In the present embodiment, one common layer 14 is formed by the nozzle coating method. However, when a plurality of common layers are provided in one organic EL element, at least one of the common layers may be formed by the nozzle coating method described above, or a plurality of the common layers may also be formed by the nozzle coating method described above.

As described above, the common layers 14 having the same film thickness can be respectively formed in a plurality rows by applying and forming the common layer 14 at intervals of m rows in the column direction. However, as shown in the following experimental examples, even when the same amount of ink is supplied in all the processes, the thickness of the common layers 14 is in the range of the same film thickness, but is slightly different for each process in some cases. That is, in the case of m = 1, the film thickness of the common layer 14 formed in the first process, and the film thickness of the common layer 14 formed in the second process are in the range of the same film thickness but are slightly different from each other. It is considered that the difference in the film thickness for each process is due to the fact that the atmosphere in which the ink dries is different for each process. For example, in the second process, the ink is applied in the atmosphere in which the ink supplied in the first process dries, and the ink applied in the second process dries in such atmosphere. The concentration of the gas generated by evaporation of the solvent is high in the atmosphere, and hence the ink applied in the second process is difficult to dry and tends to dry for a longer time as compared with the ink supplied in the first process. As the ink dries, the volume of the ink is reduced along the surface of the partition wall 3. However, it is considered that the shape of the common layer 14, which is eventually formed, is changed by the drying speed of the ink, so as to become a dome shape or a bowl shape. As a result, it is considered that the drying speed affects the film thickness of the common layer 14.

### (Experimental example)

A hole injection layer made of poly(3,4-ethylenedioxythiophene)/poly(4-styrenesulfonic acid) (PEDOT/PSS) was formed as the common layer 14 on a substrate on which a thin film made of ITO and used as the one-side electrode 12, an insulating film made of SiO₂ and used as the lattice-like insulating film 4, and a partition wall made of polyimide resin and used as the stripe-like partition wall 3 were respectively formed. The value of m was set as m = 1, and the common layer was successively formed at intervals of one row, so that the common layer was formed in all the rows by dividing the process of film formation into two processes. The hole injection layer was formed by using ink in which 35% by weight of PEDOT/PSS was dissolved in water. In each process, the same amount of the ink was applied to each of the even and odd rows. From the plurality of rows in each of which the common layer was formed, seven rows continuous in the column direction Y were selected, and the film thickness of the common layer of each of the seven rows was measured. A stylus-type film thickness meter (made by KLA-Tencor Corporation, P-16+) was used for the measurement. The measurement results are shown in Table 1. In Table 1, the even rows represent the film thickness of the common layers formed in the first process, and the odd rows represent the film thickness of the common layers formed in the second process. Note that it was confirmed that, when the ink was applied at intervals of one row, the common layer connected between the rows adjacent to each other was not formed on the partition wall, and that the ink was not connected in the column direction Y at the end portion in the row direction X.

**[Table 1]**

| | | | | | | | |
|---|---|---|---|---|---|---|---|
| Row number | 1 | 2 | 3 | 4 | 5 | 6 | 7 |
| Film thickness (nm) | 53.9 | 45.9 | 51.7 | 45.0 | 54.2 | 46.1 | 57.0 |

As shown in Table 1, it was seen that, although the same amount of ink was applied to each of the even and odd rows, there was a tendency that the film thickness of the common layer formed in the first process was smaller than the thickness of the common layer formed in the second process.

To cope with this, it is preferred that, in the present embodiment, the supply amount of the ink per unit length in the row direction is adjusted for each process so that the common layers formed in different rows have the same film thickness. Further, it is preferred that the supply amount of the ink in the succeeding process is set to be smaller than the supply amount of the ink in the preceding process.

For example, in the experimental example, it was seen that, when the same amount of the ink was applied to each of the even and odd rows, there was the tendency that the film thickness of the common layer formed in the first process was smaller than the thickness of the common layer formed in the second process. Therefore, it is preferred that the amount of the ink supplied in the second process corresponding to the succeeding process is reduced so that the common layers formed in the even and odd rows have the same film thickness.

It is preferred that the supply amount of the ink is adjusted (1) by adjusting the moving speed of the ink supply position in the row direction, or (2) by adjusting the supply amount of the ink per unit time.

When the moving speed of the ink supply position in the row direction is adjusted, the supply amount of the ink can be adjusted by adjusting the moving speed of the nozzle in the row direction X, and hence the supply amount of the ink can be highly precisely adjusted as compared with the case where the supply amount of the ink per unit time is adjusted.

There is a limit of the moving speed of the nozzle in the row direction X, and hence there is a limit in the adjustment of the supply amount of the ink by adjusting the moving speed of the nozzle in the row direction X. However, even in such case, the supply amount of the ink can be adjusted by adjusting the discharge amount of the ink per unit time, and hence it is preferred, in some cases, that the supply amount of the ink is adjusted by adjusting the supply amount of the ink per unit time.

### (Step of forming light emitting layer)

As described above, when a color display device is manufactured, for example, each of the materials of the light emitting layers needs to be separately applied in order to manufacture the three kinds of organic EL elements. For example, when each of the three kinds of light emitting layers is formed in each of the rows, each of red ink containing a material emitting red light, green ink containing a material emitting green light, and blue ink containing a material emitting blue light needs to be applied at intervals of two rows in the column direction Y For example, each of the three kinds of the light emitting layers can be applied and formed by successively applying the red ink, the green ink, and the blue ink to predetermined rows. Examples of the method for successively applying the red ink, the green ink, and the blue ink to predetermined rows include predetermined application methods, such as a printing method, an ink jet method, and a nozzle coating method. For example, similarly to the method for forming the common layer 14 described above, the light emitting layers may be formed by setting the value of m to a multiple of 2 in the method for forming the common layer 14.

After the light emitting layers are formed, predetermined organic layers, and the like, are formed by predetermined methods as required. The layers may be formed by using predetermined application methods, such as the printing method, the ink jet method, and the nozzle coating method and further by using a predetermined dry method.

### (Step of forming other-side electrode of paired electrodes on organic layer)

Next, the other-side electrode is formed. As described above, in the present embodiment, the other-side electrode is formed on the whole surface of the support substrate. Thereby, a plurality of organic EL elements can be formed on the substrate.

As described above, the organic EL element is constituted by various layers. In the following, there are described examples of the layer structure of the organic EL element, the structure of each of the layers, and the method for forming each of the layers.

The organic EL element includes a pair of electrodes, and one or more organic layers arranged between the pair of electrodes. As the one or more organic layers, one or more light emitting layers are provided. Between the anode and the cathode, not only the light emitting layer but also an organic layer different from the light emitting layer may be provided, and further an inorganic layer is provided in some cases. In the following, layers provided between the anode and the cathode are described, but among these layers, a layer containing an organic substance corresponds to an organic layer. As an organic substance constituting an organic layer, a low-molecular compound or a macromolecular compound may be used, and a mixture of a low-molecular compound and a macromolecular compound may also be used. However, a macromolecular compound is preferred, and a macromolecular compound having a polystyrene-equivalent number average molecular weight of 10³ to 10⁸ is preferred. This is because, when an organic layer is formed by the application method, an organic substance having good solubility in a solvent is preferred and because the solubility of a macromolecular compound in a solvent is generally good.

Examples of the layer to be provided between the cathode and the light emitting layer include an electron injection layer, an electron transport layer, a hole blocking layer and the like. When both the electron injection layer and the electron transport layer are provided between the cathode and the light emitting layer, the layer provided near the cathode is referred to as an electron injection layer, and the layer provided near the light emitting layer is referred to as an electron transport layer. Examples of the layer to be provided between the anode and the light emitting layer include a hole injection layer, a hole transport layer, and an electron blocking layer, and the like. When both the hole injection layer and the hole transport layer are provided, the layer provided near the anode is referred to as a hole injection layer, and the layer provided near the light emitting layer is referred to as a hole transport layer. The layers provided between the cathode and the light emitting layer, and the layers provided between the anode and the light emitting layer can be provided, as common layers, commonly for all the organic EL elements. It is preferred that, among the common layers, the common layer, which can be formed by the application method, is formed by the method of applying ink in the form of a liquid column described above.

Examples of element structures of an organic EL element are described as follows:
a) anode/light emitting layer/cathode
b) anode/hole injection layer/light emitting layer/cathode
c) anode/hole injection layer/light emitting layer/electron injection layer/cathode
d) anode/hole injection layer/light emitting layer/electron transport layer/cathode
e) anode/hole injection layer/light emitting layer/electron transport layer/electron injection layer/cathode
f) anode/hole transport layer/light emitting layer/cathode
g) anode/hole transport layer/light emitting layer/electron injection layer/cathode
h) anode/hole transport layer/light emitting layer/electron transport layer/cathode
i) anode/hole transport layer/light emitting layer/electron transport layer/electron injection layer/cathode
j) anode/hole injection layer/hole transport layer/light emitting layer/cathode
k) anode/hole injection layer/hole transport layer/light emitting layer/electron injection layer/cathode
l) anode/hole injection layer/hole transport layer/light emitting layer/electron transport layer/cathode
m) anode/hole injection layer/hole transport layer/light emitting layer/electron transport layer/electron injection layer/cathode
n) anode/light emitting layer/electron injection layer/cathode
o) anode/light emitting layer/electron transport layer/cathode
p) anode/light emitting layer/electron transport layer/electron injection layer/cathode

Further, the organic EL element may have two or more light emitting layers, and a so-called multi-photon type organic EL element may also be configured so as to have two or more light emitting layers between which a charge generation layer that generates charges is provided.

The organic EL element may be covered by a sealing member, such as a sealing film or a sealing plate, for sealing.

The organic EL element of the present embodiment may further be provided with an insulating layer having a thickness of 2 nm or less and adjacent to an electrode in order to improve the adhesiveness to the electrode and improve the charge injection property from the electrode. Further, for the purpose of improving the adhesiveness and preventing mixing at an interface, it is permissible to insert a thin buffer layer between the above-described layers.

The order of the layers to be laminated, the number of the layers, and the thickness of each of the layers can be determined appropriately by taking into account the light emission efficiency and the element life. Further, as to the anode and the cathode of the organic EL element, the anode may be arranged near the support substrate, and the cathode may be arranged at a position away from the support substrate. On the contrary, the cathode may be arranged near the support substrate, and the anode may be arranged at a position away from the support substrate. Specifically, in the configuration of a) to p) described above, each of the layers may be laminated on the support substrate in order from the left layer. On the contrary, each of the layers may be laminated on the support substrate in order from the right layer.

Next, the material and formation method of each of the layers constituting the organic EL element are described more specifically.

### <Support substrate>

As the support substrate, for example, a glass substrate, a plastic substrate, and a silicon substrate, and a substrate formed by laminating these substrates are used. Further, as the support substrate on which the organic EL element is to be formed, a substrate in which an electric circuit is formed in advance may also be used.

### <Anode>

In the case of the organic EL element having a configuration in which light emitted from the light emitting layer is taken out through an anode, a light-transmissive electrode is used as the anode. As the light-transmissive electrode, thin films made of metal oxides, metal sulfides, metals, and the like which have high electrical conductivity, can be used, and a thin film having high light transmittance is suitably used. Specifically, thin films made of indium oxide, zinc oxide, tin oxide, ITO, indium zinc oxide (abbreviated as IZO), gold, platinum, silver, copper, and the like are used, and among these, a thin film made of ITO, IZO, or tin oxide is suitably used. Examples of a method for manufacturing the anode include a vacuum deposition method, a sputtering method, an ion plating method, a plating method, and the like. Further, an organic transparent conductive film made of polyaniline or its derivatives, polythiophene or its derivatives, or the like may also be used as the anode.

For the anode, a material that reflects light may also be used, and metals, metal oxides, and metal sulfides that have a work function of 3.0 eV or more are preferred as the material.

The thickness of the anode can be determined appropriately by taking into account the light transmissivity and the electrical conductivity, and it is, for example, 10 nm to 10 µm, preferably 20 nm to 1 µm, and more preferably 50 nm to 500 nm.

### <Hole injection layer>

Examples of the hole injection material constituting the hole injection layer include oxides, such as vanadium oxide, molybdenum oxide, ruthenium oxide, and aluminum oxide, phenylamine-based, starburst-type amine-based, phthalocyanine-based, amorphous carbon, polyaniline, polythiophene derivatives, and the like.

Examples of a method for film formation of the hole injection layer include film formation from a solution which contains a hole injection material. The solvent to be used for the film formation from a solution is not particularly restricted as long as it is a solvent that dissolves the hole injection material. Examples of the solvent include chlorine-based solvents, such as chloroform, methylene chloride, and dichloroethane, ether-based solvents, such as tetrahydrofuran, aromatic hydrocarbon-based solvents, such as toluene and xylene, ketone-based solvents, such as acetone and methyl ethyl ketone, ester-based solvents, such as ethyl acetate, butyl acetate, and ethyl cellosolve acetate, and water.

Examples of the method of film formation from a solution include application methods, such as a spin coating method, a casting method, a microgravure coating method, a gravure coating method, a bar coating method, a roll coating method, a wire bar coating method, a dip coating method, a spray coating method, a screen printing method, a flexographic printing method, an offset printing method, an ink jet printing method, a nozzle coating method, and the like. It is preferred to form the hole injection layer by the nozzle coating method described above.

The thickness of the hole injection layer is determined appropriately by taking into account the electrical property and the ease of film formation. The thickness of the hole injection layer is, for example, 1 nm to 1 µm, preferably 2 nm to 500 nm, and more preferably 5 nm to 200 nm.

### <Hole transport layer>

Examples of the hole transport material constituting the hole transport layer include polyvinylcarbazole or its derivatives, polysilane or its derivatives, polysiloxane derivatives having an aromatic amine in their side chain or main chain, pyrazoline derivatives, arylamine derivatives, stilbene derivatives, triphenyldiamine derivatives, polyaniline or its derivatives, polythiophene or its derivatives, polyarylamine or its derivatives, polypyrrole or its derivatives, poly(p-phenylenevinylene) or its derivatives, or poly(2,5-thienylenevinylene) or its derivatives, and the like.

Among these, macromolecular hole transport materials, such as polyvinylcarbazole or its derivatives, polysilane or its derivatives, polysiloxane derivatives having an aromatic amine compound group in their side chain or main chain, polyaniline or its derivatives, polythiophene or its derivatives, polyarylamine or its derivatives, poly(p-phenylenevinylene) or its derivatives, or poly(2,5-thienylenevinylene) or its derivatives, are preferred as the hole transport material. Polyvinylcarbazole or its derivatives, polysilane or its derivatives, and polysiloxane derivatives having an aromatic amine in their side chain or main chain are more preferred as the hole transport material. In the case of the low-molecular hole transport material, the material is preferably used by being dispersed in a macromolecular binder.

Examples of a method for film formation of the hole transport layer include, but are not particularly restricted to, film formation from a mixed liquid containing a macromolecular binder and a hole transport material in the case of a low-molecular hole transport material and include film formation from a solution containing a hole transport material in the case of a macromolecular hole transport material.

The solvent to be used for the film formation from a solution is not particularly restricted as long as it is a solvent that dissolves the hole transport material, and, for example, a solvent exemplified as a solvent of the solution used for the film formation of the hole injection layer from a solution may be used.

Examples of the method of film formation from a solution include application methods that are the same as those for the above-described method for the film formation of the hole injection layer, and the hole transport layer is preferably formed by the nozzle coating method described above.

As the macromolecular binder to be mixed, binders that do not inhibit charge transport excessively are preferred, and binders that exhibit weak absorption to visible light are preferably used, and examples thereof include polycarbonate, polyacrylate, polymethyl acrylate, polymethyl methacrylate, polystyrene, polyvinyl chloride, polysiloxane, and the like.

The thickness of the hole transport layer is determined appropriately by taking into account the electric property and the ease of the film formation. The thickness of the hole transport layer is, for example, 1 nm to 1 µm, preferably 2 nm to 500 nm, and more preferably 5 nm to 200 nm.

### <Light emitting layer>

The light-emitting layer is usually formed mainly of an organic substance that emits fluorescence and/or phosphorescence, or the organic substance and a dopant that assists the organic substance. The dopant is added, for example, for improving the light emission efficiency or changing the light emission wavelength. The organic substance may be either a low-molecular compound or a macromolecular compound, and the light emitting layer preferably contains a macromolecular compound having a polystyrene-equivalent number average molecular weight of 10³ to 10⁸. Examples of the light emitting material constituting the light emitting layer include the following dye-based materials, metal complex-based materials, macromolecule-based materials, and dopant materials.

### (Dye-based material)

Examples of the dye-based material include, for example, cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimmers, pyrazoline dimmers, quinacridone derivatives, coumarin derivatives, and the like.

### (Metal complex-based material)

Examples of the metal complex-based material include, for example, metal complexes having, as a central metal, Al, Zn, Be, Ir, Pt or the like or rare earth metals, such as Tb, Eu, and Dy, and having, as a ligand, an oxadiazole structure, a thiadiazole structure, a phenylpyridine structure, a phenylbenzoimidazole structure, a quinoline structure, or the like, and examples thereof include metal complexes having light emission from a triplet excited state, such as iridium complexes and platinum complexes, alumiquinolinol complexes, benzoquinolinol beryllium complexes, benzooxazolyl zinc complexes, benzothiazole zinc complexes, azomethyl zinc complexes, porphyrin zinc complexes, phenanthroline europium complexes, and the like.

### (Macromolecule-based material)

Examples of the macromolecule-based material include polyparaphenylene vinylene derivatives, polythiophene derivatives, polyparaphenylene derivatives, polysilane derivatives, polyacetylene derivatives, polyfluorene derivatives, polyvinylcarbazole derivatives, and materials obtained by polymerizing the above-described dye-based materials or metal complex-based light emitting materials, and the like.

Among the above-described light emitting materials, examples of a material that emits blue light include distyrylarylene derivatives, oxadiazole derivatives, and their polymers, polyvinylcarbazole derivatives, polyparaphenylene derivatives, polyfluorene derivatives, and the like. Especially, polyvinylcarbazole derivatives, polyparaphenylene derivatives, polyfluorene derivatives, and the like, which are macromolecular materials, are preferred.

Examples of a material that emits green light include quinacridone derivatives, coumarin derivatives, and their polymers, polyparaphenylene vinylene derivatives, polyfluorene derivatives, and the like. Especially, polyparaphenylene vinylene derivatives and polyfluorene derivatives, and the like, which are macromolecular materials, are preferred.

Examples of a material that emits red light include coumarin derivatives, thiophene ring compounds, and their polymers, polyparaphenylene vinylene derivatives, polythiophene derivatives, polyfluorene derivatives, and the like. Especially, polyparaphenylene vinylene derivatives, polythiophene derivatives, and polyfluorene derivatives, and the like, which are macromolecular materials, are preferred.

### (Dopant material)

Examples of the dopant material include perylene derivatives, coumarin derivatives, rubrene derivatives, quinacridone derivatives, squarium derivatives, porphyrin derivatives, styryl-based dyes, tetracene derivatives, pyrazolone derivatives, decacyclene, phenoxazone, and the like. The thickness of such a light emitting layer is usually about 2 nm to 200 nm.

Examples of a method for the film formation of the light emitting material include a printing method, an ink jet printing method, a nozzle coating method, and the like.

### <Electron transport layer>

Known materials can be used as the electron transport material constituting the electron transport layer, and examples thereof include oxadiazole derivatives, anthraquinodimethane or its derivatives, benzoquinone or its derivatives, naphthoquinone or its derivatives, anthraquinone or its derivatives, tetracyanoanthraquinodimethane or its derivatives, fluorenone derivatives, diphenyldicyanoethylene or its derivatives, diphenoquinone derivatives, or 8-hydroxyquinoline or metal complexes of its derivatives, polyquinoline or its derivatives, polyquinoxaline or its derivatives, polyfluorene or its derivatives, and the like.

Among these, as the electron transport material, oxadiazole derivatives, benzoquinone or its derivatives, anthraquinone or its derivatives, or 8-hydroxyquinoline or metal complexes of its derivatives, polyquinoline or its derivatives, polyquinoxaline or its derivatives, and polyfluorene or its derivatives are preferred, and 2-(4-biphenylyl)-5-(4-t-butylphenyl)-1,3,4-oxadiazole, benzoquinone, anthraquinone, tris(8-quinolinol)aluminum, and polyquinoline are more preferred.

Examples of a method for formation of the electron transport layer include, but are not particularly restricted to, a vacuum vapor deposition method from a powder or film formation from a solution or a molten state in the case of a low-molecular electron transport material, and include film formation from a solution or a molten state in the case of a macromolecular electron transport material. When a film is formed from a solution or a molten state, a macromolecular binder may be used together. Examples of the method for formation of the electron transport layer from a solution include application methods that are the same as those for the film formation of the hole transport layer as described above.

The thickness of the electron transport layer is determined appropriately by taking into account the electric property and the ease of film formation, and is, for example, 1 nm to 1 µm, preferably 2 nm to 500 nm, and more preferably 5 nm to 200 nm.

### <Electron injection layer>

An optimal material is selected appropriately as the material constituting the electron injection layer according to the kind of the light emitting layer, and examples thereof include alkali metals, alkaline earth metals, alloys containing one or more of alkali metals and alkaline earth metals, and oxides, halides, and carbonates of the alkali metals or the alkaline earth metals, or mixtures of these substances, and the like. Examples of the alkali metals and the oxides, halides, and carbonates of the alkali metals include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, lithium carbonate, and the like.

Further, examples of the alkaline earth metals and the oxides, halides, and carbonates of the alkaline earth metals include magnesium, calcium, barium, strontium, magnesium oxide, magnesium fluoride, calcium oxide, calcium fluoride, barium oxide, barium fluoride, strontium oxide, strontium fluoride, magnesium carbonate, and the like. The electron injection layer may be made of a layered body in which two or more layers are laminated and examples thereof include LiF/Ca, and the like. The electron injection layer is formed by a vacuum deposition method, a sputtering method, a printing method, or the like. The thickness of the electron injection layer is preferably about 1 nm to about 1 µm.

### <Cathode>

The material of the cathode is preferably a material that has a small work function, easily injects electrons into a light emitting layer, and has high electrical conductivity. For such an organic EL element in which light is taken out from the anode side, the material of the cathode is preferably a material having high visible light reflectance in order to reflect the light from the light emitting layer on the cathode toward the anode side. For the cathode, it is possible to use, for example, alkali metals, alkaline earth metals, transition metals, metals of Group 13 of the periodic table, and the like. As the material of the cathode, there are used metals, such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, alloys of two or more of the foregoing metals, alloys of one or more of the foregoing metals and one or more selected from among gold, silver, platinum, copper, manganese, titanium, cobalt, nickel, tungsten, and tin, or graphite or graphite intercalation compounds, and the like.

Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy, and the like. Transparent conductive electrodes made of conductive metal oxides, conductive organic substances, and the like can be used as the cathode. Specifically, examples of the conductive metal oxides include indium oxide, zinc oxide, tin oxide, ITO, IZO, and the like, and examples of the conductive organic substances include polyaniline or its derivatives, polythiophene or its derivatives, and the like. The cathode may be made of a layered article in which two or more layers are laminated. Moreover, an electron injection layer may also be used as a cathode.

The thickness of the cathode is determined appropriately by taking into account the electrical conductivity and the durability, and it is, for example, 10 nm to 10 µm, preferably 20 nm to 1 µm, and more preferably 50 nm to 500 nm.

Examples of a method for manufacturing the cathode include methods, such as a vacuum deposition method, a sputtering method, and a laminating method by which a metal thin film is bonded by thermocompression.

### <Insulating layer>

Examples of the material of the insulating layer include metal fluorides, metal oxides, organic insulating materials, and the like. Examples of an organic EL element in which an insulating layer having a thickness of 2 nm or less is provided include one in which an insulating layer having a thickness of 2 nm or less is provided next to a cathode, and one in which an insulating layer having a thickness of 2 nm or less is provided next to an anode.

In the above embodiment, a method for manufacturing a light emitting device in which an organic EL element is formed on a substrate has been described, and particularly a method for forming the common layer has been described in detail. However, the above-described method for forming the common layer is applicable to not only the pattern formation of the common layer but also the pattern formation of a general thin film.

That is, when a manufacturing method, such as a method for forming a pattern of a thin film, is performed, a plurality of rows extending in a row direction different from a predetermined column direction are set at predetermined intervals in the column direction on a predetermined substrate, so that each of a plurality of thin films can be formed in each row so as to have the same thickness. This method for manufacturing thin films includes a step of forming the thin films by applying and forming thin films for each of predetermined rows in such a manner that, while ink in the form of a liquid column and containing a material to be formed as the thin films is supplied onto the predetermined rows, the ink supply position is moved in the row direction. In the step of forming the thin films, the process of applying and forming the thin films at intervals of m rows (symbol "m" denotes a natural number) in the column direction is performed (m+1) times to the rows not provided with thin films.

### Reference Signs List

- 1: Light emitting device
- 2: Support substrate
- 3: Partition wall
- 4: Insulating film
- 5: Recessed section
- 6: Opening
- 11: Organic EL element
- 12: One-side electrode
- 13: Other-side electrode
- 14: Common layer (organic layer)
- 15: Light emitting layer (organic layer)

## Claims

1. A method for manufacturing a light emitting device including a plurality of organic EL elements, a plurality of rows extending in a row direction different from a predetermined column direction being set on a plane at predetermined intervals in the column direction, the plurality of organic EL elements being provided in the row at predetermined intervals in the row direction, each of the organic EL elements including a pair of electrodes and a common layer that is commonly provided for each of the organic EL elements between the pair of electrodes, the common layers of the organic EL elements formed in different rows having the same film thicknesses, the method comprising:
a step of forming one-side electrode of the pair of electrodes;
a step of forming the other-side electrode of the pair of electrodes; and
a step of forming the common layer by applying and forming the common layer in a predetermined row in such a manner that, while ink in the form of a liquid column and containing a material to be formed as the common layer is supplied to the predetermined row, the ink supply position is moved in the row direction,
wherein, in the step of forming the common layer, the process of applying and forming the common layer is performed (m+1) times (symbol "m" denotes a natural number) at intervals of m row in the column direction to the rows not provided with the common layer.

2. The method according to claim 1, wherein the supply amount of the ink per unit length in the row direction is adjusted for each process so that the common layers formed in the different rows have the same film thickness.

3. The method according to claim 2, wherein the supply amount of the ink per unit length in the row direction in the succeeding process is set to be smaller than the supply amount of the ink per unit length in the row direction in the preceding process.

4. The method according to one of claim 2 and claim 3, wherein the supply amount of the ink is adjusted by adjusting the moving speed of the ink supply position in the row direction.

5. The method according to one of claim 2 and claim 3, wherein the supply amount of the ink is adjusted by adjusting the supply amount of the ink per unit time.

6. The method according to one of claim 1 to claim 5, wherein the value of m is set to 1.

7. A method for manufacturing a plurality of thin films configured such that a plurality of rows extending in a row direction different from a predetermined column direction are set on a predetermined substrate at predetermined intervals in the column direction, each of the plurality of thin films being formed in each of the rows so as to have the same thickness, the method comprising:
a step of forming the thin films by applying and forming the thin films in predetermined rows in such a manner that, while ink in the form of a liquid column and containing a material to be formed as the thin film is supplied onto the predetermined rows, the ink supply position is moved in the row direction,
wherein, in the step of forming the thin films, the process of applying and forming the thin films is performed (m+1) times (symbol "m" denotes a natural number) at intervals of m row in the column direction to the rows not provided with the thin films.
